# EUROPEAN PATENT APPLICATION

(11) **EP 4 716 199 A1**
(43) Date of publication of application: **25.03.2026**
(21) Application number: 25197479.6
(22) Date of filing: 21.08.2025
(51) Int. Cl.: H04M 1/02, H04M 1/04, H04M 1/72409

(54) **PROTECTIVE BOOT FOR AN ELECTRONIC DEVICE**

(30) Priority: 24.09.2024 CN 202411332873
(71) Applicant: Hand Held Products, Inc., Charlotte, NC 28202 (US)
(72) Inventor: CLARK, Gregory Scott, Charlotte, 28202 (US); YODER, Jordan Dean, Charlotte, 28202 (US); CHANEY, David E., Charlotte, 28202 (US); YAO, Jingjing, Charlotte, 28202 (US)
(74) Representative: Haseltine Lake Kempner LLP

(57) **Abstract**

A protective boot for an electronic device is disclosed. The electronic device comprising a guide rail on a side of the electronic device. The protective boot comprising a rim that is configured to extend around a periphery of the electronic device, a strap portion that comprise a first portion that extends from the rim, and a bottom portion that defines a cut-out relative to the first portion of the strap portion. Further, the cut-out is configured to allow the guide rail of the electronic device to mate with a corresponding feature of a charging base when the rim of the protective boot extends around the periphery of the electronic device.

## Description

### TECHNOLOGICAL FIELD

Example embodiments of the present disclosure relate generally to a protective boot, and more particularly, to a protective boot for an electronic device and a method thereof.

### BACKGROUND

Industrial handheld devices are designed to withstand harsh environments with features like rugged casings, reinforced screens, and resistance to dust and water. The industrial handheld devices are built to endure tough conditions, ensuring reliable performance even in challenging settings. However, despite their durability, the industrial handheld devices are not indestructible, which necessitates the use of additional protective measures such as rubber boots. The rubber boots provide an extra layer of defense against physical damage, but they also introduce a limitation such as users must remove the rubber boot to charge the device using a dock. Such extra step of removing the rubber boot for charging the device complicates the charging process, and thus makes it less efficient and less user-friendly in fast-paced industrial environments.

The inventors identified numerous deficiencies and problems in in existing technologies and processes, which are the subjects of embodiments described herein. Through applied effort, ingenuity, and innovation, many of these deficiencies and problems have been solved by developing solutions that are included in embodiments of the present disclosure, many examples of which are described in detail herein.

### BRIEF SUMMARY

The following presents a summary of some example embodiments to provide a basic understanding of some aspects of the present disclosure. This summary is not an extensive overview and is intended to neither identify key or critical elements nor delineate the scope of such elements. It will also be appreciated that the scope of the disclosure encompasses many potential embodiments in addition to those here summarized, some of which will be further described in the detailed description that is presented later.

In an example embodiment, a protective boot for an electronic device is disclosed. The electronic device comprising a guide rail on a side of the electronic device. The protective boot comprising a rim that is configured to extend around a periphery of the electronic device, a strap portion that comprise a first portion that extends from the rim, and a bottom portion that defines a cut-out relative to the first portion of the strap portion. Thereafter, the cut-out is configured to allow the guide rail of the electronic device to mate with a corresponding feature of a charging base when the rim of the protective boot extends around the periphery of the electronic device.

In some embodiments, the guide rail comprises a groove. In some embodiments, the corresponding feature of the charging base is a protrusion.

In some embodiments, the strap portion comprises a second portion that extends from the first portion. In some embodiments, the second portion is configured to extend behind the electronic device.

In some embodiments, the protective boot further comprises a top end and a bottom end that are configured to protect a top edge and a bottom edge of the electronic device. In some embodiments, the charging base further comprises a charging jack that is configured to charge the electronic device.

In another example embodiment, an electronic device assembly is disclosed. The electronic device assembly comprising an electronic device that comprises a side comprising a guide rail and a protective boot comprising a rim that is configured to extend around a periphery of the electronic device, a strap portion that comprise a first portion that extends from the rim, and a bottom portion that defines a cut-out relative to the first portion of the strap portion. Further, the electronic device comprises a charging base that comprises a corresponding feature that is mated with the guide rail of the electronic device.

In some embodiments, the cut-out is configured to allow the guide rail of the electronic device to mate with the corresponding feature of the charging base when the rim of the protective boot extends around the periphery of the electronic device.

In some embodiments, the electronic device corresponds to a mobile phone, a handheld computer, or a mobile terminal.

In another example embodiment, a method is disclosed. The method comprising extending a rim of a protective boot around a periphery of an electronic device; extending a first portion of a strap portion of the protective boot from the rim; and allowing, via a cut-out of a bottom portion of the protective boot relative to the first portion of the strap portion, a guide rail of the electronic device to mate with a corresponding feature of a charging base when the rim of the protective boot extends around the periphery of the electronic device.

The above summary is provided merely for purposes of summarizing some exemplary embodiments to provide a basic understanding of some aspects of the disclosure. Accordingly, it will be appreciated that the above-described embodiments are merely examples and should not be construed to narrow the scope or spirit of the disclosure in any way. It will be appreciated that the scope of the disclosure encompasses many potential embodiments in addition to those here summarized, some of which are further explained within the following detailed description and its accompanying drawings.

### BRIEF DESCRIPTION OF THE DRAWINGS

Having thus described certain example embodiments of the present disclosure in general terms, reference will hereinafter be made to the accompanying drawings, which are not necessarily drawn to scale, and wherein:
FIG. 1A illustrates a front view of a protective boot in accordance with an example embodiment of the present disclosure;
FIG. 1B illustrates a side view of the protective boot in accordance with an example embodiment of the present disclosure;
FIG. 1C illustrates an isometric view of the protective boot in accordance with an example embodiment of the present disclosure;
FIG. 2A illustrates an isometric view of an electronic device detachably coupled with a charging base in accordance with an example embodiment of the present disclosure;
FIG. 2B illustrates a side view of the electronic device in accordance with an example embodiment of the present disclosure;
FIG. 2C illustrates an expanded view of the electronic device having a guide rail in accordance with an example embodiment of the present disclosure;
FIG. 3A illustrates a top view of the charging base in accordance with an example embodiment of the present disclosure;
FIG. 3B illustrates a front view of the charging base in accordance with an example embodiment of the present disclosure;
FIG. 3C illustrates a perspective view of the charging base in accordance with an example embodiment of the present disclosure;
FIG. 4A illustrates a front view of an electronic device assembly in accordance with an example embodiment of the present disclosure; and
FIG. 4B illustrates a perspective view of the electronic device assembly in accordance with an example embodiment of the present disclosure.

### DETAILED DESCRIPTION

Some embodiments will now be described more fully hereinafter with reference to the accompanying drawings, in which some, but not all, embodiments of the present disclosure are shown. Indeed, various embodiments may be embodied in many different forms and should not be construed as limited to the embodiments set forth herein; rather, these embodiments are provided so that this disclosure will satisfy applicable legal requirements.

The components illustrated in the figures represent components that may or may not be present in various embodiments of the present disclosure described herein such that embodiments may include fewer or more components than those shown in the figures while not departing from the scope of the present disclosure. Some components may be omitted from one or more figures or shown in dashed line for visibility of the underlying components.

As used herein, the term "comprising" means including but not limited to and should be interpreted in the manner it is typically used in the patent context. Use of broader terms such as comprises, includes, and having should be understood to provide support for narrower terms such as consisting of, consisting essentially of, and comprised substantially of.

The phrases "in various embodiments," "in one embodiment," "according to one embodiment," "in some embodiments," and the like generally mean that the particular feature, structure, or characteristic following the phrase may be included in at least one embodiment of the present disclosure and may be included in more than one embodiment of the present disclosure (importantly, such phrases do not necessarily refer to the same embodiment).

The word "example" or "exemplary" is used herein to mean "serving as an example, instance, or illustration." Any implementation described herein as "exemplary" is not necessarily to be construed as preferred or advantageous over other implementations.

If the specification states a component or feature "may," "can," "could," "should," "would," "preferably," "possibly," "typically," "optionally," "for example," "often," or "might" (or other such language) be included or have a characteristic, that a specific component or feature is not required to be included or to have the characteristic. Such a component or feature may be optionally included in some embodiments or it may be excluded.

The present disclosure provides various embodiments of a protective boot of an electronic device. Embodiments of the present disclosure may comprise a rim that is configured to extend around a periphery of the electronic device. Embodiments of the present disclosure may comprise a strap portion that may further comprise a first portion that extends from the rim. Embodiments of the present disclosure may comprise a bottom portion that defines a cut-out relative to the first portion of the strap portion. The cut-out may be configured to allow a guide rail of the electronic device to mate with a corresponding feature of a charging base when the rim of the protective boot extends around the periphery of the electronic device.

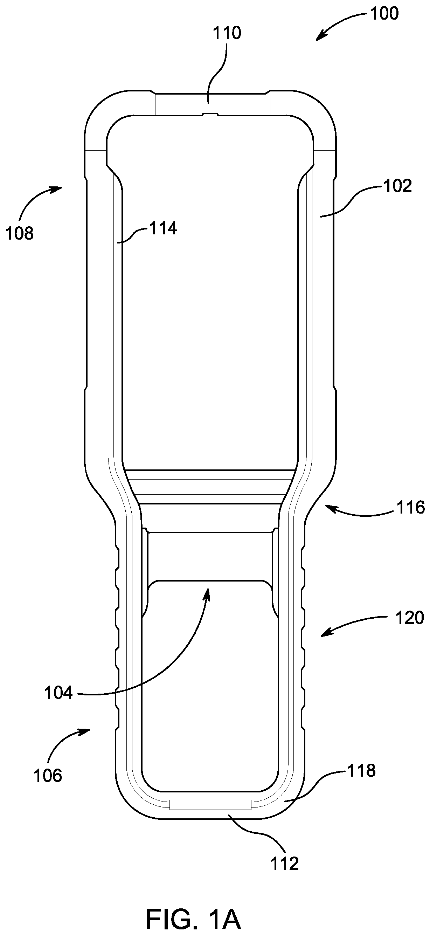

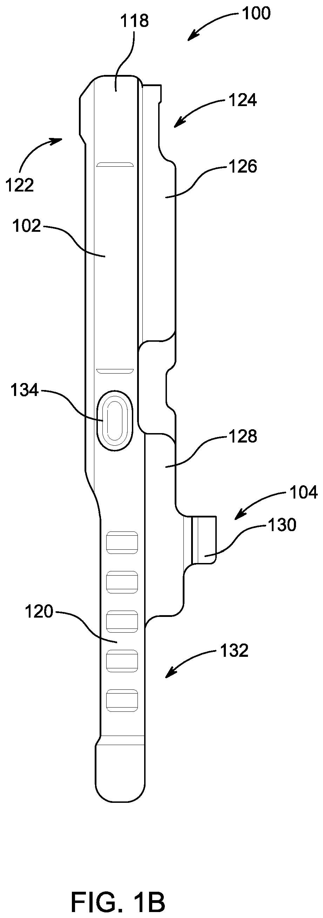

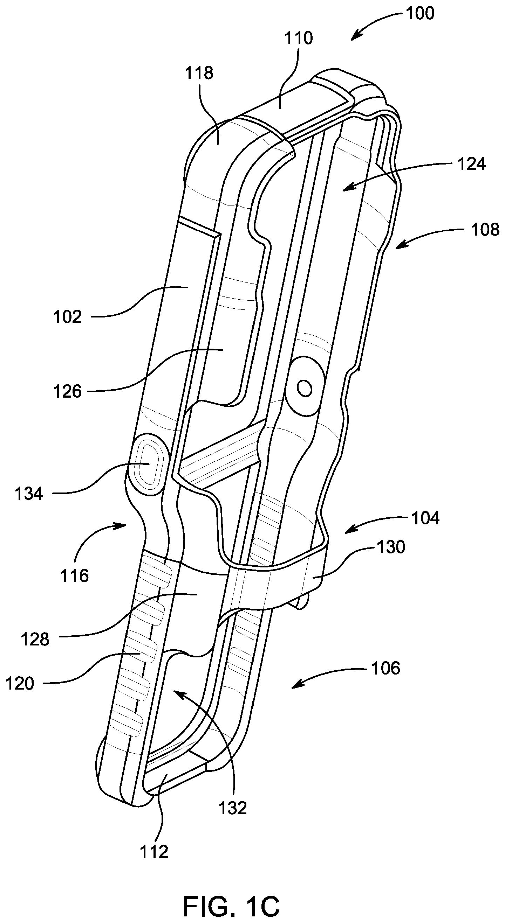

FIG. 1A illustrates a front view of a protective boot 100, in accordance with an example embodiment of the present disclosure. FIG. 1B illustrates a side view of the protective boot 100, in accordance with an example embodiment of the present disclosure. FIG. 1C illustrates an isometric view of the protective boot 100, in accordance with an example embodiment of the present disclosure.

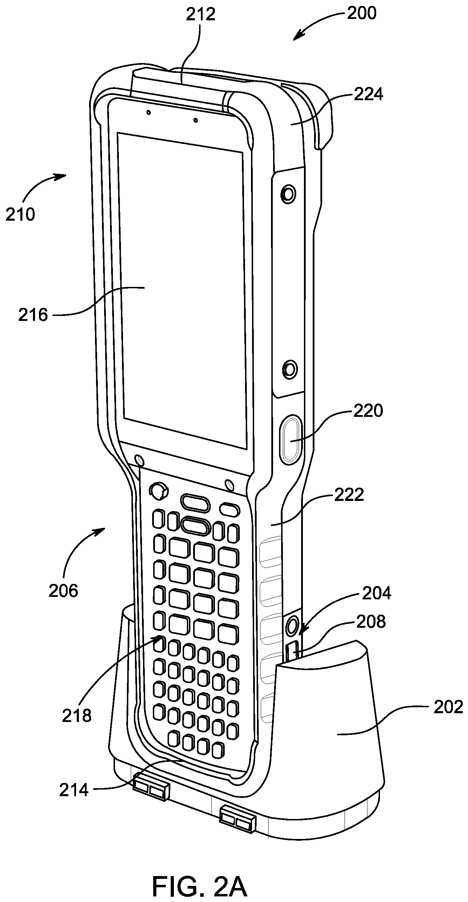

In some embodiments, the protective boot 100 may comprise a rim 102, a strap portion 104, and a bottom portion 106. In some embodiments, the protective boot 100 may be configured to encase an electronic device 200 (FIG. 2A). In some embodiments, the protective boot 100 may be configured to provide safeguard the electronic device 200 from various external factors. The external factors may include but are not limited to dropping from a height, impact from collision with external objects. Further, the protective boot 100 may be constructed with various materials. Further, the materials may include, but are not limited to, silicone, rubber, or high-impact plastic. In some embodiments, the material for the protective boot 100 may be selected such that the protective boot 100 may provide impact resistance and shock absorption. In some embodiments, the electronic device 200 may comprise at least one of a handheld data terminal, scanner, or mobile computer.

In some embodiments, the protective boot 100 may comprise a top portion 108 and the bottom portion 106. In some embodiments, the electronic device 200 may comprise a top portion 210 (FIG. 2A) and a bottom portion 206 (FIG. 2A). In some embodiments, the top portion 108 of the protective boot 100 may be configured to safeguard the top portion 210 of the electronic device 200. In some embodiments, the top portion 210 of the electronic device 200 may comprise a screen 216 (FIG. 2A). In some embodiments, the top portion 108 of the protective boot 100 may comprise a top end 110. In some embodiments, the top end 110 of the top portion 108 may be configured to safeguard a top edge 212 (FIG. 2A) of the electronic device 200. In some embodiments, the top end 110 of the protective boot 100 may extend along a width of the top portion 210 of the electronic device 200. In some embodiments, the bottom portion 106 of the protective boot 100 may be configured to safeguard the bottom portion 206 of the electronic device 200. Further, the bottom portion 206 of the electronic device 200 may comprise a keypad 218 (FIG. 2A). In some embodiments, the bottom portion 106 of the protective boot 100 may comprise a bottom end 112. In some embodiments, the bottom end 112 of the bottom portion 106 may be configured to safeguard a bottom edge 214 (FIG. 2A) of the electronic device 200. In some embodiments, the bottom end 112 of the protective boot 100 may extend along a width of the bottom portion 206 of the electronic device 200. In some embodiments, the width of the top portion 210 of the electronic device 200 is greater than the width of the bottom portion 206 of the electronic device 200. Similarly, the width of the top portion 108 of the protective boot 100 is greater than the width of the bottom portion 106 of the protective boot 100.

In some embodiments, the protective boot 100 may comprise a front side 122. In some embodiments, the front side 122 of the protective boot 100 may be configured to safeguard the electronic device 200 from various hazards that may damage a front side 122 (FIG. 1B) of the electronic device 200. In some embodiments, the front side 122 of the protective boot 100 may comprise a design that may corresponds to an open-front design. Further, the design of the front side 122 of the protective boot 100 may allow access to the screen 216 of the electronic device 200. In some embodiments, the front side 122 of the protective boot 100 may comprise a plurality of first extended edges 114. In some embodiments, the plurality of first extended edges 114 may be configured to safeguard each edge of the front side 122 of the electronic device 200. In some embodiments, the protective boot 100 may comprise a back side 124 (FIG. 1C). In some embodiments, the back side 124 of the protective boot 100 may be configured to safeguard from the various hazards that may damage a back side 124 of the electronic device 200. In some embodiments, the back side 124 of the protective boot 100 may comprise a plurality of second extended edges 126 (FIGS. 1B-1C). In some embodiments, each of the plurality of second extended edges 126 may be configured to protect edges of the back side 124 of the electronic device 200.

In some embodiments, the protective boot 100 may comprise the rim 102. Further, the rim 102 of the protective boot 100 may be configured to extend around a periphery 222 (FIG. 2A) of the electronic device 200. In some embodiments, the rim 102 of the protective boot 100 may be configured to safeguard the periphery 222 of the electronic device 200. In some embodiments, the rim 102 of the protective boot 100 may be configured to suppress impact from falling from the height and/or impact from collision with the objects. In some embodiments, the rim 102 of the protective boot 100 may be constructed to cover the periphery 222 of the electronic device 200. In some embodiments, the rim 102 of the protective boot 100 may comprise one or more curved sections 116. In some embodiments, the one or more curved sections 116 of the rim 102 may be configured to allow the protective boot 100 to properly encase the electronic device 200.

In some embodiments, the protective boot 100 may comprise the strap portion 104. In some embodiments, the strap portion 104 may be configured to extend from the back side 124 of the protective boot 100. In some embodiments, the strap portion 104 of the protective boot 100 may be configured to provide support to the back side 124 of the electronic device 200. In some embodiments, the strap portion 104 of the protective boot 100 may be constructed on the bottom portion 106 of the protective boot 100. In some embodiments, the strap portion 104 of the protective boot 100 may comprise a first portion 128 (FIG. 1B) and a second portion 130 (FIG. 1B). In some embodiments, the first portion 128 of the strap portion 104 may extend from the rim 102 of the protective boot 100. In some embodiments, the first portion 128 of the strap portion 104 may be monolithic with two extended edges of the plurality of second extended edges 126 of the protective boot 100. In some embodiments, the second portion 130 of the strap portion 104 may be monolithic with the first portion 128 of the strap portion 104 such that the second portion 130 of the strap portion 104 may provide support to the electronic device 200. In some embodiments, the strap portion 104 of the protective boot 100 may extend behind a battery pack of the electronic device 200. The strap portion 104 may be positioned proximate to a top end of the battery pack to allow for the battery pack to be removed while the protective boot 100 is installed on the electronic device 200.

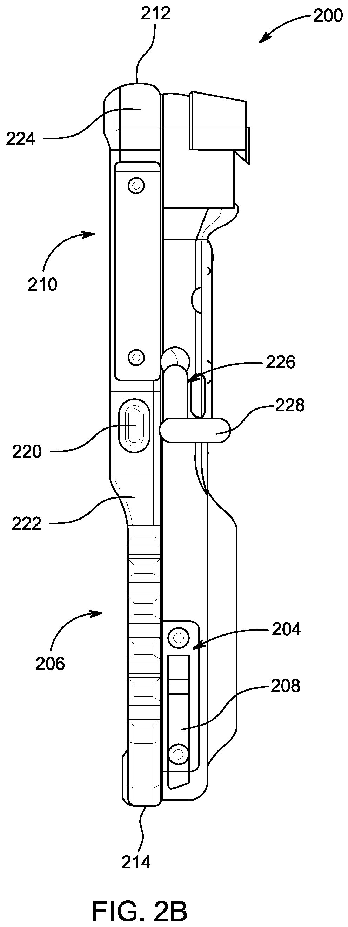

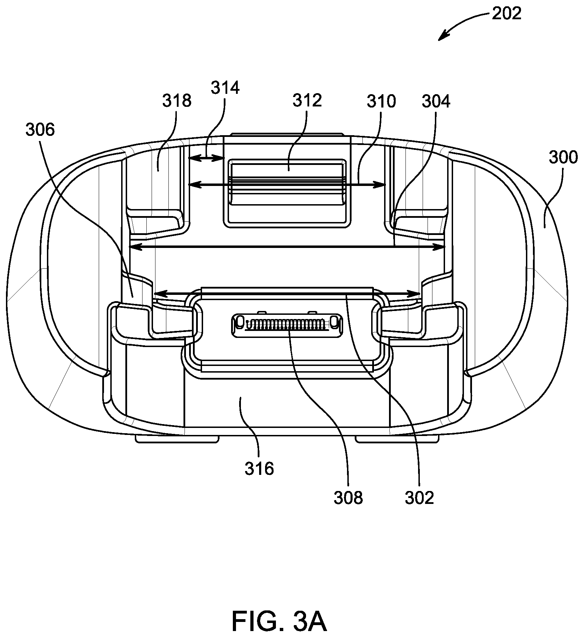

In some embodiments, the bottom portion 106 of the protective boot 100 may define a cut-out 132 (FIG. 1B). Further, the cut-out 132 may be relative to the first portion 128 of the strap portion 104. In some embodiments, the cut-out 132 of the bottom portion 106 may be constructed by various processes. The processes may include but are not limited to cutting, trimming, molding etc. In some embodiments, the cut-out 132 of the bottom portion 106 may be aligned with sides of the bottom portion 206 of the electronic device 200. In some embodiments, the cut-out 132 of the bottom portion 106 may be configured to expose sides of the bottom portion 206 of the electronic device 200. In some embodiments, the electronic device 200 may comprise a guide rail 204 (FIGS. 2B-2C). In some embodiments, each side of the bottom portion 206 of the electronic device 200 may comprise the guide rail 204. In some embodiments, the cut-out 132 of the bottom portion 106 may be configured to allow the guide rail 204 of the electronic device 200 to mate with a corresponding feature 306 (FIG. 3A) of a charging base 202 (FIG. 2A), when the rim 102 of the protective boot 100 extends around the periphery 222 of the electronic device 200. As such, the electronic device 200 may be placed on the charging base 202 and charged without removing or adjusting the protective boot 100.

In some embodiments, the protective boot 100 may comprise a plurality of corners 118. Further, the plurality of corners 118 of the protective boot 100 may be configured to safeguard a plurality of corners 224 (FIG. 2A) of the electronic device 200. In some embodiments, each of the plurality of corners 118 may be reinforced with a rounded padding. In various examples, each of the plurality of corners 118 may be configured to prevent damage to the electronic device 200 from drops or impacts. In some embodiments, the rim 102 of the protective boot 100 may comprise at least one indentation 134 (FIG. 1B). In some embodiments, the at least one indentation 134 of the rim 102 may be configured to accommodate a control button 220 (e.g., a power button or volume button) (FIG. 2A) of the electronic device 200. In some embodiments, the at least one indentation 134 of the rim 102 of the protective boot 100 may be configured to provide access of the control button 220 to a user without removing the protective boot 100. In various examples, the at least one indentation 134 of the rim 102 may be constructed such that the user may easily press the control button 220. In some embodiment, the rim 102 of the protective boot 100 may comprise a textured area 120. In some embodiments, the textured area 120 of the rim 102 may be configured to provide grip to the user while handling the electronic device 200.

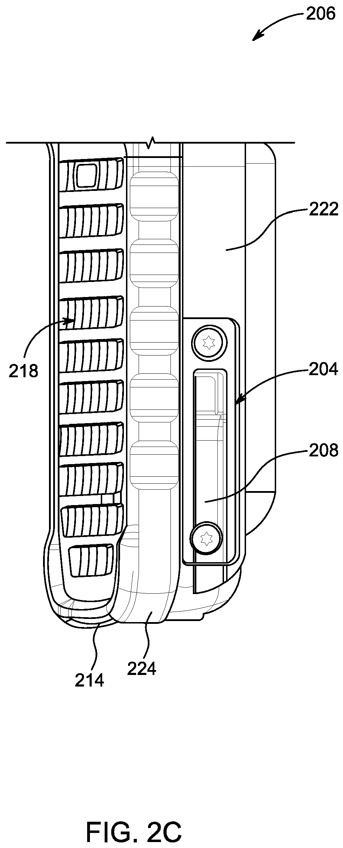

FIG. 2A illustrates a perspective view of the electronic device 200 detachably coupled with the charging base 202, in accordance with an example embodiment of the present disclosure. FIG. 2B illustrates a side view of the electronic device 200, in accordance with an example embodiment of the present disclosure. FIG. 2C illustrates an expanded view of the electronic device 200 having a guide rail 204, in accordance with an example embodiment of the present disclosure..

In one instance, when a battery of the electronic device 200 gets discharged, then the electronic device 200 that may be encased within the protective boot 100 may be required to be detachably coupled to the charging base 202 so that the battery may be charged. In another instance, when the battery of the electronic device 200 gets discharged, then the electronic device 200 that is not encased within the protective boot 100 may be required to be detachably coupled to the charging base 202 so that the battery may be charged. Stated differently, when the battery of the electronic device 200 is discharged, the electronic device may be placed on the charging base 202 when the protective boot 100 is installed on the electronic device 200 and when the protective boot 100 is not installed on the electronic device. In some embodiments, the charging base 202 may comprise at least one slot, as shown by 302 (FIG. 3A). Further, the at least one slot 302 of the charging base 202 may be configured to receive the electronic device 200. In some embodiments, the at least one slot 302 may comprise the corresponding feature 306. In various examples, the at least one slot 302 may comprise a plurality of corresponding features. In some embodiments, the corresponding feature 306 of the at least one slot 302 may facilitate in coupling of the electronic device 200 with the charging base 202. In some embodiments, the corresponding feature 306 may correspond to a protrusion that extends from a main body of the charging base 202.

As illustrated in FIGS. 2B-2C, the guide rail 204 on each side of the bottom portion 206 of the electronic device 200 may facilitate in detachable coupling of the electronic device 200 with the charging base 202. In some embodiments, the cut-out 132 of the bottom portion 106 may be configured to allow the guide rail 204 of the electronic device 200 to mate with the corresponding feature 306 of the charging base 202 without removing the protective boot 100 from the electronic device 200. In some embodiments, the guide rail 204 may comprise a groove 208. In some embodiments, the groove 208 of the guide rail 204 may be configured to receive the corresponding feature 306, when the electronic device 200 gets plugged-in to the charging base 202. In some embodiments, the corresponding feature 306 of the charging base 202 may be configured to slide-into the groove 208 of the guide rail 204 of the electronic device 200. In some embodiments, the groove 208 may be constructed on the guide rail 204 such that when the corresponding feature 306 mates with the guide rail 204, then the electronic device 200 orients in a vertical plane from the charging base 202.

In some embodiments, the electronic device 200 may correspond to a mobile phone, a handheld computer, or a mobile terminal. In some embodiments, the electronic device 200 may comprise the top portion 210 and the bottom portion 206. In some embodiments, the top portion 210 may comprise the top edge 212, and the bottom portion 206 may comprise the bottom edge 214. In some embodiments, the top portion 210 of the electronic device 200 may comprise the screen 216. Further, the bottom portion 206 of the electronic device 200 may comprise the keypad 218. In some embodiments, the screen 216 of the electronic device 200 may be configured to provide visuals to the user associated with a target application. In some embodiments, the keypad 218 of the electronic device 200 facilitates the user to provide various commands to the electronic device 200 while performing various applications.

In some embodiments, the electronic device 200 may comprise the control button 220. Further, the control button 220 may correspond to the power button or the volume button. In some embodiments, the bottom portion 206 of the electronic device 200 may comprise the bottom edge 214. Further the bottom edge 214 of the electronic device 200 may comprise a charging port (not shown). In some embodiments, the charging base 202 may comprise a charging jack 308 (FIG. 3A). In some embodiments, the charging port of the electronic device 200 may be configured to connect with the charging jack 308, when the electronic device 200 is placed into the at least one slot 302 of the charging base 202. In some embodiments, the charging jack 308 of the charging base 202 may be configured to charge the electronic device 200, when the rim 102 extends around the periphery 222 of the electronic device 200. In some embodiments, the plurality of corners 118 of the protective boot 100 may be configured to safeguard the plurality of corners 224 of the electronic device 200.

As illustrated in FIG. 2B, the electronic device 200 may comprise a communication port 226. In some embodiments, the communication port 226 may be constructed on the periphery 222 of the electronic device 200. In some embodiments, the communication port 226 of the electronic device 200 may be configured to enable a wired communication between the electronic device 200 and various other external devices such as, mobile terminals, scanners, hand-held devices, servers etc. In various examples, the communication port 226 may facilitate the electronic device 200 to transfer and/or receive data from the external devices through a communication bus (not shown). In some embodiments, the electronic device 200 may comprise a covering tab 228. In some embodiments, the covering tab 228 of the electronic device 200 may be movably coupled with the communication port 226 of the electronic device 200. In some embodiments, the covering tab 228 may be configured to safeguard the communication port 226 from various environmental factors such as, dust, debris, moisture etc.

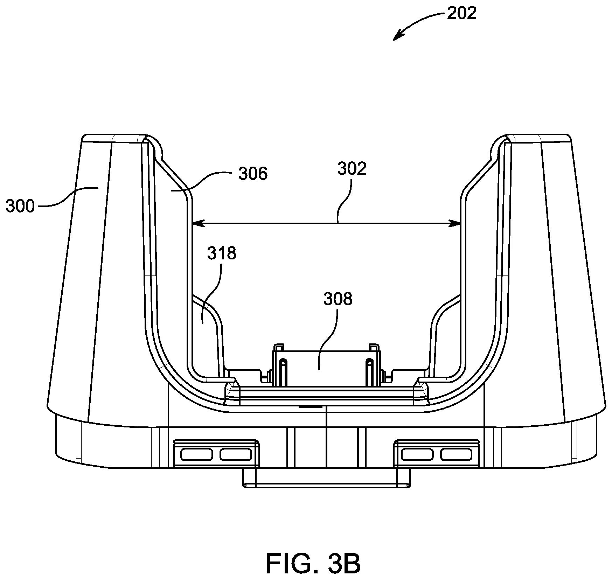

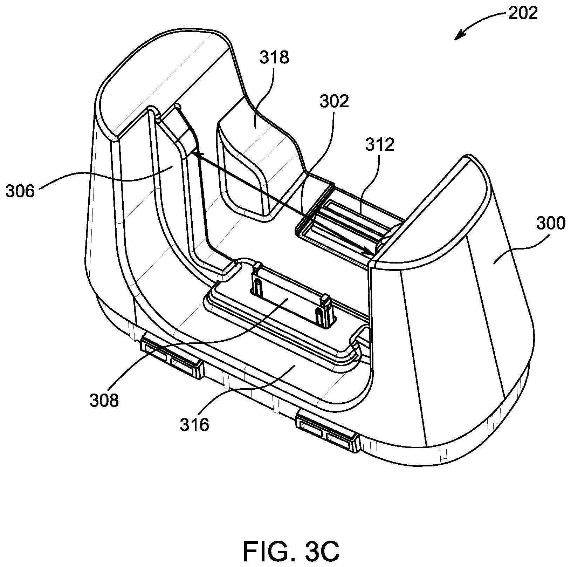

FIG. 3A illustrates a top view of the charging base 202, in accordance with an example embodiment of the present disclosure. FIG. 3B illustrates a front view of the charging base 202, in accordance with an example embodiment of the present disclosure. FIG. 3C illustrates a perspective view of the charging base 202, in accordance with an example embodiment of the present disclosure.

In some embodiments, the charging base 202 may be configured to charge the electronic device 200. In some embodiments, the charging base 202 may comprise a housing 300. Further, the housing 300 may be configured to cover various components associated with the charging base 202. In some embodiments, the housing 300 may be constructed with various materials. The materials may include but are not limited to polycarbonate, metal, silicone, rubber, ceramic, or reinforced plastic. In some embodiments, the materials of the charging base 202 may be selected such that the housing 300 may withstand extreme conditions. In some embodiments, the housing 300 of the charging base 202 may be constructed with various shapes. The shape may include but are not limited to a U-shape, V-shape, planar, or elliptical.

In some embodiments, the charging base 202 may be connected with a power source (e.g., an electrical outlet). In some embodiments, the power source may be configured provide a power supply to the charging base 202. In some embodiments, the charging base 202 may be configured to receive an input power supply from the power source. In some embodiments, the charging base 202 may be configured to regulate the input power supply received from the power source. Further, the charging base 202 may be configured to provide an output power supply to the electronic device 200. Further, the input power supply received from the power source ranges between 220V-240V. Further, the output power supply supplied from the charging base 202 to the electronic device 200 may range between 5V-24V.

In some embodiments, the charging base 202 may comprise the at least one slot, as shown by 302. In some embodiments, the at least one slot 302 may be configured to receive the bottom portion 206 of the electronic device 200. For example, the portion of the bottom portion 206 of the electronic device 200 that includes the groove 208 of the guide rail 204 may be received within the slot 302. In some embodiments, the electronic device 200 may be positioned perpendicular to the charging base 202. In some embodiments, the at least one slot 302 may be constructed through various processes. The processes may include but are not limited to a molding, casting etc. In some embodiments, the charging base 202 may comprise an another slot, as shown by 304. Further, the another slot 304 of the charging base 202 may be configure to receive and accommodate the bottom portion 206 of the electronic device 200 that is behind the portion that includes the guide rail 204. In some embodiments, the at least one slot 302 of the charging base 202 may comprise the corresponding feature 306. Further, the corresponding feature 306 may be configured to mate with the groove 208 of the guide rail 204 of the electronic device 200. In some embodiments, the corresponding feature 306 may be constructed on parallel walls of the housing 300 of the charging base 202. In some embodiments, the charging base 202 may comprise the charging jack 308. In some embodiments, the charging jack 308 of the charging base 202 may be configured to connect with the charging port of the electronic device 200, when the electronic device 200 is placed into the at least one slot 302 of the charging base 202.

In some embodiments, the charging base 202 may comprise a locking section, as shown by 310. In some embodiments, the locking section 310 of the charging base 202 may facilitate locking of the electronic device 200 when placed into the at least one slot 302. In some embodiments, the locking section 310 of the charging base 202 may comprise a lock 312. Further, the lock 312 of the locking section 310 may be configured to lock the electronic device 200 within the at least one slot 302 and provide stabilization to the electronic device 200 within the at least one slot 302. In some embodiments, the locking section 310 of the charging base 202 may comprise one or more channels, as shown by 314. In some embodiment, the bottom edge 214 of the electronic device 200 may comprise a latch (not shown). In some embodiments, the latch of the electronic device 200 may configured to be detachably coupled with the lock 312 of the charging base 202 to lock the electronic device 200 within the at least one slot 302. In some embodiments, the one or more channels 314 may be configured to receive and accommodate an outer periphery defined by the latch of the electronic device 200.

In some embodiments, the charging base 202 may comprise a docking area 316. In some embodiments, the docking area 316 of the charging base 202 may be configured to accommodate the bottom end 112 of the bottom portion 106 of the protective boot 100 encasing the electronic device 200. In some embodiments, the docking area 316 of the charging base 202 may define a width that may be adequate to accommodate the bottom end 112 of the bottom portion 106. In some embodiments, the docking area 316 may correspond to a planar surface to accommodate the electronic device 200 accommodated within the protective boot 100 perpendicular to the charging base 202.

In some embodiments, the charging base 202 may comprise an another corresponding feature 318. Further, the another corresponding feature 318 of the charging base 202 may be configured to extend from the parallel walls of the charging base 202. In some embodiments, the another corresponding feature 318 of the charging base 202 may be configured to provide support the back side 124 of the electronic device 200. In some embodiments, the another corresponding feature 318 may define a width greater than width of the corresponding feature 306. In some embodiments, the another corresponding feature 318 of the charging base 202 may be configured to provide support to the electronic device 200 when the electronic device 200 is locked by the lock 312 of the charging base 202.

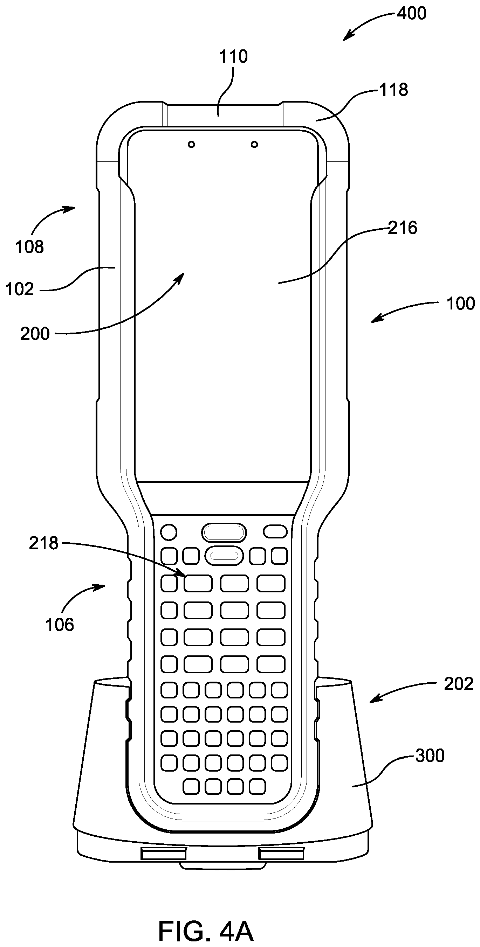

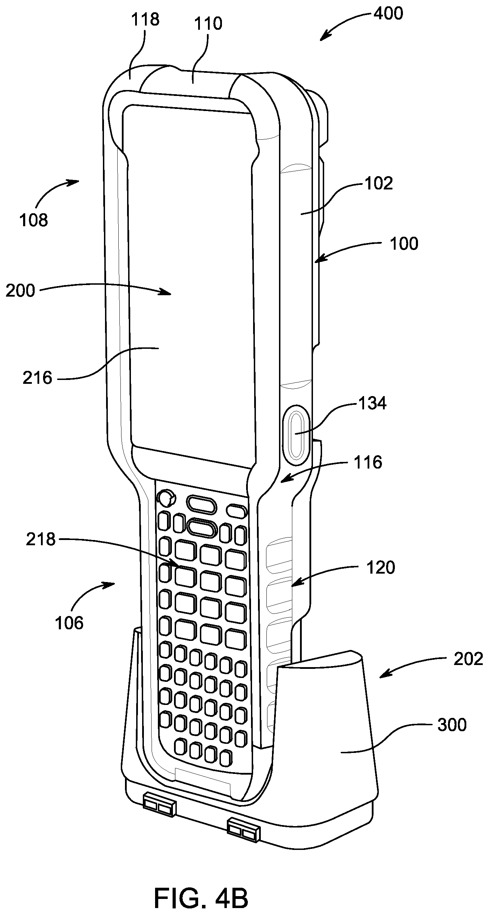

FIG. 4A illustrates a front view of an electronic device assembly 400, in accordance with an example embodiment of the present disclosure. FIG. 4B illustrates a perspective view of the electronic device assembly 400, in accordance with an example embodiment of the present disclosure. FIGS. 4A-4B are described in conjunction with FIGS. 1A-3C.

In some embodiments, the electronic device assembly 400 may comprise the electronic device 200, the protective boot 100, and the charging base 202. In some embodiments, the electronic device 200 may correspond to a mobile phone, a handheld computer, or a mobile terminal. In some embodiments, the protective boot 100 may be configured to encase the electronic device 200. In some embodiments, the protective boot 100 may comprise the rim 102. Further, the rim 102 may be configured to extend around the periphery 222 of the electronic device 200. In some embodiments, the rim 102 may be configured to safeguard sides of the electronic device 200. In some embodiments, the protective boot 100 may comprise the front side 122 and the back side 124. In some embodiments, the back side 124 of the protective boot 100 may be configured to safeguard the back side 124 of the electronic device 200. In some embodiments, the back side 124 of the protective boot 100 may comprise the strap portion 104. Further, the strap portion 104 of the protective boot 100 may comprise the first portion 128 and the second portion 130.

In some embodiments, the first portion 128 of the strap portion 104 may extend from the rim 102 of the protective boot 100. In some embodiments, the second portion 130 of the strap portion 104 may extend from the first portion 128 of the protective boot 100. In some embodiments, the second portion 130 of the strap portion 104 of the protective boot 100 may be configured to extend behind the electronic device 200. In some embodiments, the strap portion 104 of the protective boot 100 may be configured to provide support to the electronic device 200 that is encased within the protective boot 100. In some embodiments, the electronic device assembly 400 may comprise the electronic device 200 that is encased within the protective boot 100 and detachably coupled to the charging base 202.

In some embodiments, a method is disclosed. The method comprising one or more operations. At an operation, the rim 102 of the protective boot 100 may be configured to extend around the periphery 222 of the electronic device 200. Further, the rim 102 may be configured to safeguard the periphery 222 of the electronic device 200 from various hazards. At another operation, the first portion 128 of the strap portion 104 of the protective boot 100 may be configured to extend from the rim 102. Further, the strap portion 104 may comprise the second portion 130. Further, the second portion 130 may be configured to extend from the first portion 128. Further, the second portion 130 of the strap portion 104 may be configured to extend behind the electronic device 200 that may be encased within the protective boot 100. At another operation, the cut-out 132 of the bottom portion 106 of the protective boot 100 relative to the first portion 128 of the strap portion 104 may be configured to allow the guide rail 204 of the electronic device 200 to mate with the corresponding feature 306 of the charging base 202 when the rim 102 of the protective boot 100 extends around the periphery 222 of the electronic device 200.

The present invention may offer charging to the electronic device 200 with the protective boot 100 or without the protective boot 100, which enhances convenience and efficiency of the electronic device 200. The rim 102 of the present invention protects the electronic device 200 from accidental drops, impacts, dust, and moisture even while charging. The protective boot 100 increases lifespan of the electronic device 200 by minimizing physical handling of the electronic device 200. The present invention focuses on saving time in various applications such as logistics, construction, or fieldwork by minimizing downtime of the electronic device 200. The protective boot 100 makes the electronic device 200 compatible to various docking stations (i.e. charging base 202).

Many modifications and other embodiments of the disclosure set forth herein will come to mind to one skilled in the art to which the present disclosure pertains having the benefit of the teachings presented in the foregoing descriptions and the associated drawings. Therefore, it is to be understood that the present disclosure is not to be limited to the specific embodiments disclosed and that modifications and other embodiments are intended to be included within the scope of the appended claims. Moreover, although the foregoing descriptions and the associated drawings describe example embodiments in the context of certain example combinations of elements and/or functions, it should be appreciated that different combinations of elements and/or functions may be provided by alternative embodiments without departing from the scope of the appended claims. In this regard, for example, different combinations of elements and/or functions than those explicitly described above are also contemplated as may be set forth in some of the appended claims. Although specific terms are employed herein, they are used in a generic and descriptive sense only and not for purposes of limitation.

## Claims

1. A protective boot for an electronic device, the electronic device comprising a guide rail on a side of the electronic device, the protective boot comprising:
a rim that is configured to extend around a periphery of the electronic device;
a strap portion that comprises a first portion that extends from the rim; and
a bottom portion that defines a cut-out relative to the first portion of the strap portion, wherein the cut-out is configured to allow the guide rail of the electronic device to mate with a corresponding feature of a charging base when the rim of the protective boot extends around the periphery of the electronic device.

2. The protective boot of claim 1, wherein the guide rail comprises a groove.

3. The protective boot of claim 1, wherein the corresponding feature of the charging base is a protrusion.

4. The protective boot of claim 1, wherein the strap portion comprises a second portion that extends from the first portion.

5. The protective boot of claim 4, wherein the second portion is configured to extend behind the electronic device.

6. The protective boot of claim 1, further comprising a top end and a bottom end that are configured to protect a top edge and a bottom edge of the electronic device.

7. The protective boot of claim 1, wherein the charging base further comprises a charging jack that is configured to charge the electronic device.

8. An electronic device assembly comprising:
an electronic device comprising a side comprising a guide rail;
a protective boot comprising:
a rim that extends around a periphery of the electronic device;
a strap portion that comprises a first portion that extends from the rim; and
a bottom portion that defines a cut-out relative to the first portion of the strap portion; and
a charging base that comprises a corresponding feature that is mated with the guide rail of the electronic device.

9. The electronic device assembly of claim 8, wherein the cut-out is configured to allow the guide rail of the electronic device to mate with the corresponding feature of the charging base when the rim of the protective boot extends around the periphery of the electronic device.

10. The electronic device assembly of claim 8, wherein the guide rail comprises a groove.

11. The electronic device assembly of claim 8, wherein the corresponding feature of the charging base is a protrusion.

12. The electronic device assembly of claim 8, wherein the strap portion comprises a second portion that extends from the first portion.

13. The electronic device assembly of claim 12, wherein the second portion is configured to extend behind the electronic device.

14. The electronic device assembly of claim 8, wherein the protective boot further comprising a top end and a bottom end that are configured to protect a top edge and a bottom edge of the electronic device.

15. The electronic device assembly of claim 8, wherein the charging base further comprising a charging jack that is configured to charge the electronic device.
